# EUROPEAN PATENT SPECIFICATION

(11) **EP 0 588 136 B1**
(45) Date of publication and mention of the grant of the patent: **13.11.1996**
(21) Application number: 93113812.7
(22) Date of filing: 30.08.1993
(51) Int. Cl.: H01C 17/06, H01B 1/14

(54) **Polymer thick film resistor compositions**
Zusammensetzung für einen Polymer-Dickschichtwiderstand
Composition pour résistance à couche épaisse en polymère

(30) Priority: 15.09.1992 US 944996
(43) Date of publication of application: 23.03.1994
(73) Proprietor: E.I. DU PONT DE NEMOURS AND COMPANY, Wilmington Delaware 19898 (US)
(72) Inventor: Dorfman, Jay Robert, Durham, North Carolina 27713 (US)
(74) Representative: von Kreisler, Alek, Dipl.-Chem.

(56) References cited:
- US-A- 2 795 680
- US-A- 2 866 057
- US-A- 3 173 885
- PATENT ABSTRACTS OF JAPAN vol. 1, no. 28 (C-009)28 March 1977 & JP-A-51 144 435

## Description

### FIELD OF THE INVENTION

This invention is directed to polymer thick film resistor compositions. In particular, the invention is directed to such compositions which are suitable for making resistive elements for use in voltage indicators.

### BACKGROUND OF THE INVENTION

Polymer thick film (PTF) resistor compositions are screenable pastes which are used to form resistive elements in electronic applications. Such compositions contain resistive filler material dispersed in polymeric resins which remain an integral part of the final composition after processing. The compositions can be processed at relatively low temperatures, namely the temperatures required to cure the resin. The actual resistivity/conductivity of the compositions will vary depending on the desired end use. PTF materials have received wide acceptance in commercial products, notably for flexible membrane switches, touch keyboards, automotive parts and telecommunications.

Another use for PTF resistor elements is in voltage indicators for use in testing batteries. Kiernan et al., in U.S. patent 4,723,656, have described such a voltage indicator which can be integrally associated with a battery package.

The resistive elements are usually prepared by printing the PTF composition, or ink, onto a sheet in a pattern which has many replications of the resistor. It is important to have resistance uniformity across the sheet, I.e., the resistance of elements on one side of the sheet should be the same as that of elements on the opposite side. Variability in the resistance can significantly reduce the yield.

In addition, to be suitable for use in any of the above described devices, it is important that the resistive element be both compositionally and functionally stable. In particular, the change in the resistance of the resistive element over the course of time and upon extended exposure to conditions of humidity and heat must not exceed about 5-7%.

Heretofore, the resistive element for such devices has consisted of a dispersion of silver powder and carbon particles in a polyurethane or epoxy resin.

In particular, US-A 3 173 885 to Short discloses a resistor composition prepared. by mixing together finely divided. silver, graphite and. a resin binder dissolved in an organic solvent. Further, from JP-A 51-144 435 there is known a composition wherein finely divided carbon particles having a surface area of greater than 500 m²/g are mixed. with a thermosetting resin dissolved. in an organic solvent

However, it has been found to be difficult to produce such resistor elements with suitable resistance uniformity and stability.

### SUMMARY OF THE INVENTION

The invention is therefore directed in its primary aspect to a polymer thick film resistor composition
(1) finely divided conductive metal particles having a surface area of 0.3 to 3.0 m²/g,
(2) finely divides particulate material particles selected from carbon, silica, alumina and mixtures thereof having a surface area greater than 100 m²/g
(3) a thermoplastic resin, dissolved in
(4) an organic solvent,
wherein the composition is substantially curable within 2.5 minutes by heating to a temperature of 135°C, and further wherein the volume raUo of particulate material to resin is at least about 3.5, and the weight ratio of solvent to resin is about 3 to about 5.

In a second aspect, the invention is directed to a process as defined in claim 14, for preparing resistive elements comprising printed layers ot the above-described. polymer thick film ink upon a substrate which process comprises heating of the layer to effect full curing of the polymers and conversion of the composition to the solid state.

The invention is further directed to a composition as defined in claim 9, and to a process as defined in claim 15.

### DETAILED DESCRIPTION OF THE INVENTION

Polymer thick film inks are generally printed onto a substrate, e.g., polyethylene terephthalate, and then cured, i.e., dried, by heating, to form a resistive element. To be acceptable, an ink should (1) have the rheological properties which result in good printing characteristics, and (2) should result in a resistive element which has the appropriate electrical properties, has the appropriate physical properties, i.e., is durable, flexible and not brittle, and has good stability over time. The key test used to predict stability over time is a post-cure process, where resistance before and after the post-cure is monitored and recorded as percent change. The post-cure can be either boiling water (206-212F; 97-100 °C) immersion for 10 minutes or oven post-curing, e.g. 250F (121 °C) for 10 minutes. In general, a resistance change of less than 5% in the boiling water test and less than 7% in the oven post-cure test is considered to be quite good.

### A. Conductive Metal

Any stable conductive metal with suitable electrical properties can be used in the PTF compositions of the invention. Particularly suitable metals include silver, gold and copper. Mixtures of the metals can also be used.

The metal particles should be finely divided and have a particle size within the range of 0.1-20 micrometers, preferably within the range of 1-10 micrometers. However, it is essential that the average surface area be in the range of 0.3 to 3.0 m²/g, and preferably 0.7 to 1.3 m²/g. The particles may be of either flake or "spherical" configuration, although, generally, a flake configuration provides the necessary surface area.

It should be noted, that some finely divided metal powders, notably silver flake, contain surfactants that are used in the manufacture of the metal particulate form. Although surfactants are not a necessary component in the PTF compositions of the invention, the presence of the surfactant is generally not detrimental.

The metal particles are generally present in an amount of from 30% to 75% by weight based on the weight of the ink; preferably from 40% to 50% by weight.

### B. Particulate Material

The particulate material is high surface area material which contributes to the resistance stability of the printed resistor. The material should be chemically inert and have a conductivity substantially less than the conductive metal. The suitable materials are selected from carbon black, silica and alumina, and mixtures thereof. The surface area of the material is greater than 100 m²/g, preferably 200 m²/g.

The amount of particulate material present in the PTF composition is determined by the volume ratio of particulate material to polymeric resin. This ratio is at least 3.5, and preferably greater than 4.0. A preferred amount of particulate material is in the range of 5 to 10% by weight, based on the weight of the ink.

When carbon is used as the particulate material, It also will provide some conductivity to the printed resistor. When a resistive element with low conductivity is needed, it may not be necessary to add further conductive metal to the carbon. Thus the carbon can function both as the electrically conductive filler and the high surface area particulate filler in the PTF ink. Such compositions are also included in the scope of the present invention. When carbon is used as the conductive material and the particulate, high surface area material, the volume ratio of carbon to resin should still be greater than 3.5 and preferably greater than 4.0. In general, the carbon will be present in an amount of 10 to 15% by weight, based on the weight of the PTF ink.

### C. Resin

The resin is a thermoplastic polymeric material. Suitable resins include phenoxy resins, vinylidene chloride, polyesters, polyurethanes and epoxy resins. Most preferred are phenoxy resins having a molecular weight of greater than 10,000.

The amount of resin present is balanced with the amount of high surface area material such that the volume ratio of high surface area material to resin is greater than 3.5 and preferably greater than 4.0. In general, the resin will be 15 to 30% by weight, based on the weight of the organic medium (resin plus solvent plus any other organic materials). Preferably the resin is 18-22% by weight, based on the weight of the organic medium. The organic medium is generally 25 to 75% by weight, based on the weight of the PTF ink.

### D. Organic Solvent

The organic solvent serves as the vehicle in which all the other components are dispersed. The volatility of the solvent is an important factor which influences the resistance stability of the printed resistive element. When evaluating the volatility of the solvent, both the base volatility of the solvent alone, and the volatility of the solvent when interacting with the thermoplastic resin should be taken into consideration.

The organic solvent alone should have a volatility rating of greater than 10,000. The volatility rating is measured as the time to 90% evaporation using a thin-film evaporometer according to ASTM Test D 3539-87, Method B. Solvents which have a volatility rating of less than 10,000 will evaporate too quickly resulting in PTF inks which are not stable, i.e., dry out too quickly. Solvents which have a very high volatility rating will be likely to evaporate too slowly resulting in poor resistance stability as measured by post-cure tests. A preferred range for the volatility rating is between 10,000 and 50,000.

The volatility of the solvent in combination with the thermoplastic resin should be such that the PTF can be substantially cured within 2.5 minutes by heating to a temperature of 135°C. By "substantially cured" it is meant that no more than 5% of the solvent in the ink remains after the heating step.

Examples of suitable solvents include aromatic and aliphatic hydrocarbons, esters, acetates, glycol ethers, and glycol ether acetates. A preferred solvent is dipropylene glycol monomethyl ether, having a volatility rating of 16,000.

The solvent is generally 70 to 85% by weight, based on the weight of the organic medium (resin plus solvent plus any other organic materials). Preferably the resin is 78-82% by weight, based on the weight of the organic medium. The organic medium is generally 25 to 75% by weight, based on the weight of the PTF ink.

Dispersants can be included with the solvent to prevent agglomeration of the particulate materials. Any conventional dispersants can be used. Preferred dispersants are fatty acid derivatives. The dispersant is generally present in an amount of 0.1 to 1.0% by weight, based on the weight of the PTF ink.

Other additives may be included with the solvent to improve the printing characteristics of the ink as long as they do not adversely affect the electrical properties and stability of the resulting resistive element. The additives include stabilizers, plasticizers, wetting agents, deaerators, and. foam inhibitors.

### E. Substrate

The substrate used for printing the resistive elements can be almost any substrate suitable for the electronic application intended. The substrate should be stable up to 150°C. The thickness of the substrate is governed by the end use. Examples of suitable substrates include polyester, polyaramid, polycarbonate, polyimide, polyether sulfone, polyether ether ketone, and FR4 (epoxy/glass laminate). Polyester substrates are preferred.

### F. Ink Preparation and Printing

In the preparation of the compositions of the present invention, the particulate solids are mixed with the resin, organic solvent and any other additives and dispersed with suitable equipment, such as a three-roll mill. This results in a suspension of the solids in the organic medium, i.e., the PTF ink.

The ink composition is then applied to a substrate, such as polyester, by a screen printing process. The printed material is dried, typically at 120 to 145°C to for 2 to 3 minutes.

The following examples further illustrate the present invention.

### EXAMPLES

### Materials

| | |
|---|---|
| Carbon | Carbon powder having a surface area of 200 m²/g |
| Dispersant | Mixture of 30% N-tallow-1,3-propanediamine dioleate and 70% tallow oils |
| Phenoxy | Polyhydroxyether polymer, MW = 10,000 to 30,000 |
| Polyester | Polymer of dimethyl terephthalate/ethylene glycol/isophthalic acid/neopentyl glycol |
| Polyurethane | Polyester urethane elastomer; Q-Thane\, K. J. Quinn & Co., (Malden, MA) |
| Vinylidene | Copolymer of vinylidene chloride and acrylonitrile |
| Silica | Fumed silica having a surface area of 300 m²/g |
| Silver | Silver flake having a surface area of 0.90 m²/g |
| Solvent I | Cyclohexanone, having a volatility rating of 10,000 |
| Solvent II | Dipropylene glycol monomethylether, having a volatility rating of 16,000 |
| Solvent III | Ethylene diacetate, having a volatility rating of 21,000 |
| Solvent IV | Mixture of aliphatic dibasic acid esters, MW_156, having a volatility rating of 49,000 |
| Solvent V | Diethylene glycol monomethylether acetate, having a volatility rating of 76,000 |

### Resistive Element

The medium (containing solvent, dissolved polymer, and other additives), high surface area particulate material, and conductive metal, if present, were mixed together. The mixture was then placed on a three roll-mill where proper dispersion of all the particulates was achieved. The resistive ink was then screen printed onto a 127 µm (5.0 mil) thick polyethylene terephthalate substrate in a wedge-shaped pattern and cured for 2,5 minutes at 135°C.

A conductive PTF silver ink, Du Pont 5007 (E. I. du Pont de Nemours & Co., Wilmington, DE), was printed onto the cured printed substrate and cured as above. Subsequently, a UV-curable PTF dielectric ink, Du Pont 5014 (E. I. du Pont de Nemours & Co., Wilmington. DE), was printed over this and exposed to UV radiation at 750 mW/cm². The dielectric encapsulated the resistive pattern.

The entire circuit was then cured for an additional 2.5 minutes at 135 °C, and. the subsequent resistance was measured as R₀.

### Test Procedures

### Boiling Water Post-Cure Test:

The cured circuit, in which the printed PTF resistor layer had been overcoated with dielectric, was immersed in boiling water for a period of 10 minutes. After drying, the resistance was measured again. The percent change in resistance relative to R₀ was determined. A change of 5% or less was considered to be satisfactory.

### Oven Post-Cure Test:

The cured circuit, in which the printed PTF resistor layer had been overcoated with dielectric, was heated to a temperature of 121°C for 10 minutes. The resistance was then measured again. The percent change in resistance relative to R₀ was determined. A change of 7% or less was considered to be satisfactory.

### Example 1

This example illustrates the use of a PTF resistor ink in which carbon is the only conductive material.

The PTF ink had the following composition, (where the percentages are by weight based on the weight of the PTF ink):

| | |
|---|---|
| Carbon | 11.5% |
| Medium | 88.0% |
| Dispersant | 0.5% |

The medium had the following composition (where the percentages are by weight based on the weight of the medium):

| | |
|---|---|
| Phenoxy Resin | 20% |
| Solvent II | 80% |

The volume ratio of carbon to resin was 4.7.

The resistance changes in the post-cure tests were as follows:

| | |
|---|---|
| Boiling Water Test | 1.0% |
| Oven Test | 0.5 |

When large sheets of the resistor pattern were printed, they were found to have a small coefficient of variation across the sheet, i.e., they had good linearity.

### Example 2

This example illustrates the effect of the carbon to resin ratio on the post-cure resistance changes.

PTF resistor inks were made having the following compositions (where the percentages are by weight based on the weight of the PTF ink):

| **Component** | Example | | | | |
|---|---|---|---|---|---|
| | **2A** | **2B** | **2C** | **2D** | **2E** |
| Silver | 44.0 | 44.0 | 44.0 | 42.0 | 44.0 |
| Carbon | 3.0 | 4.2 | 5.0 | 6.5 | 7.0 |
| Dispersant | 1.0 | 1.0 | 1.0 | 0.5 | 0.5 |
| Phenoxy | 10.4 | 10.2 | 10.0 | 10.2 | 9.7 |
| Solvent II | 41.6 | 40.6 | 40.0 | 40.8 | 38.8 |

The carbon/resin volume ratios and the resulting post-cure test results are given below. The data clearly indicate that when the carbon/resin volume ratio is less than 3.5 (Examples 2A and 2B) the resistance change is outside the acceptable limit in the post-cure tests.

| | % Resistance Change | | |
|---|---|---|---|
| **Example** | **Carbon/Resin** | **Boiling Water** | **Oven** |
| 2A | 2.0 | 27.0 | 10.4 |
| 2B | 3.0 | 11.0 | 7.8 |
| 2C | 4.0 | 7.9 | 6.9 |
| 2D | 4.5 | 4.2 | 6.9 |
| 2E | 5.1 | 2.0 | 4.5 |

When large sheets of the resistor pattern were printed using the compositions in Examples 2C-E, they were found to have a small coefficient of variation across the sheet, I.e.. they had good linearity.

### Example 3

This example illustrates the use of different thermoplastic resins in the PTF ink compositions of the invention.

PTF resistor inks were made having the following compositions (where the percentages are by weight based on the weight of the PTF ink):

| | Comparative Example | | |
|---|---|---|---|
| **Component** | **3A** | **3B** | **3C** |
| Silver | 44.0 | 38.0 | 37.2 |
| Carbon | 7.0 | 6.7 | 6.8 |
| Dispersant | 0.5 | 0.5 | 0.5 |
| Phenoxy | 9.7 | - | - |
| Vinyl | - | 11.2 | - |
| Polyester | - | - | 5.7 |
| Polyurethane | - | - | 10.8 |
| Solvent II | 38.8 | 44.6 | 39.0 |
| Carbon/Resin (v/v) | 5.1 | 3.6 | 3.5 |

The post-cure test results are given below. The phenoxy and the vinylidene chloride resins give superior post-cure resistance stability. It should be noted that acceptable results can be obtained with the polyester/polyurethane resin if other components are adjusted (e.g., the carbon/resin volume ratio is increased).

| | % Resistance Change | |
|---|---|---|
| **Example** | **Boiling Water** | **Oven** |
| 3A | 2.0 | 4.5 |
| 3B | 3.8 | 1.6 |
| 3C | 10.5 | 12.2 |

### Example 4

This example illustrates the effect of solvent volatility on the post-cure resistance stability.

PTF resistor inks were made having the following compositions (where the percentages are by weight based on the weight of the PTF ink):

| | Example | | | |
|---|---|---|---|---|
| **Component** | **4A** | **4B** | **4C** | **4D** |
| Silver | 44.0 | 44.0 | 44.0 | 44.0 |
| Carbon | 7.0 | 7.0 | 7.0 | 7.0 |
| Dispersant | 0.5 | 0.5 | 0.5 | 0.5 |
| Phenoxy Resin | 9.7 | 9.7 | 9.7 | 9.7 |
| Solvent I | 38.8 | - | - | - |
| Solvent II | - | 38.8 | - | - |
| Solvent III | - | - | - | - |
| Solvent IV | - | - | 38.8 | - |
| Solvent V | - | - | - | 38.8 |
| Carbon/Resin (v/v) | 5.1 | 5.1 | 5.1 | 5.1 |

The post-cure test results are given below. The data clearly indicate the improvement in post-cure stability with solvents having a volatility rating in the range of 10,000 to 50,000 (Examples 4A, 4B, 4C, and 4C). As the volatility rating is increased above 50,000 (Example 4E), the percent resistance change begins to rise and continues to rise.

| | % Resistance Change | |
|---|---|---|
| **Example** | **Boiling Water** | **Oven** |
| 4A | 2.5 | 2.2 |
| 4B | 2.4 | 2.1 |
| 4C | 1.9 | 2.4 |
| 4D | 4.7 | 5.6 |

### Example 5

This example illustrates the use of a different high surface area particulate material in the PTF inks of the invention.

PTF resistor inks were made having the following compositions (where the percentages are by weight based on the weight of the PTF ink):

| | Example | |
|---|---|---|
| **Component** | **5A** | **5B** |
| Silver | 44.0 | 30.0 |
| Carbon | 7.0 | - |
| Silica | - | 3.5 |
| Dispersant | 0.5 | 0.5 |
| Phenoxy | 9.7 | - |
| Vinylidene | - | 13.1 |
| Solvent II | 38.8 | 52.9 |
| Particulate Resin (v/v) | 5.1 | 3.5 |

The post-cure test results are given below. The data clearly indicate that high surface area particulate material other than carbon black can be used to provide good post-cure stability.

| | % Resistance Change | |
|---|---|---|
| **Example** | **Boiling Water** | **Oven** |
| 5A | 2.1 | 2.2 |
| 5B | 2.3 | 2.0 |

### Example 6

This example illustrates a different PTF ink composition according to the invention.

A PTF resistor ink was made having the following composition (where the percentages are by weight based on the weight of the PTF ink):

| Component | Wt.% |
|---|---|
| Silver | 44.0 |
| Carbon | 7.0 |
| Dispersant | 0.5 |
| Vinyl Resin | 12.5 |
| Solvent III | 50.0 |
| Carbon/Resin (v/v) | |

The post-cure test results are given below., showing excellent post-cure stability.

| | % Resistance Change | |
|---|---|---|
| **Example** | **Boiling Water** | **Oven** |
| 6A | 2.8 | 1.1 |

## Claims

1. A polymer thick film resistor composition comprising:
(1) finely divided conductive metal particles having a surface area of 0.3 to 3.0 m²/g,
(2) finely divided particulate material selected from carbon, silica, alumina, and mixtures thereof having a surface area greater than 100 m²/g (3) a thermoplastic resin, dissolved in
(4) an organic solvent,
wherein the composition is substantially curable within 2.5 minutes by heating to a temperature of 135 °C, and further wherein the volume ratio of particulate material to resin is at least 3.5, and the weight ratio of solvent to resin is 3 to 5.

2. The composition of claim 1 wherein the conductive metal is selected from the group consisting of silver, gold, copper and mixtures thereof.

3. The composition of claim 1 wherein the conductive metal has a surface area of 0.7 to 1.3 m²/g.

4. The composition of claim 1 wherein the particulate material has a surface area greater than 200 m²/g.

5. The composition of claim 1 wherein the thermoplastic resin is selected from the group consisting of phenoxy resin, epoxy resin, vinylidene chloride, polyester, polyurethane and mixtures thereof.

6. The composition of claim 1 wherein the solvent has a volatility rating greater than 10,000.

7. The composition of claim 6 wherein the solvent has a volatility rating of 10,000 to 50.000.

8. The composition of claim 1 suitable for fabricating the resistor element of a voltage indicator comprising:
(1) finely divided silver particles having a surface area of 0.3 to 3.0 m²/g,
(2) finely divided carbon particles having a surface area greater than 100 m²/g,
(3) a phenoxy resin, dissolved in
(4) an organic solvent having a volatility rating of 10,000 to 50,000.

9. A polymer thick film resistor composition comprising:
(1) finely divided carbon particles having a surface area greater than 100 m²/g,
(2) a thermoplastic resin, dissolved in
(3) an organic solvent,
wherein the composition is substantially curable within 2.5 minutes by heating to a temperature of 135 °C, and further wherein the volume ratio of carbon to resin is at least 3.5, and the weight ratio of solvent to resin is 3 to 5.

10. The composition of claim 9 wherein the carbon particles have a surface area greater than 200 m²/g.

11. The composition of claim 10 wherein the thermoplastic resin is selected from the group consisting of phenoxy resin, epoxy resin, vinylidene chloride, polyester, polyurethane and mixtures thereof.

12. The composition of claim 9 wherein the solvent has a volatility rating greater than 10,000.

13. The composition of claim 12 wherein the solvent has a volatility rating of 10,000 to 50,000.

14. A process for preparing a resistive element comprising a substrate having printed. thereon a layer of the composition of claim 1 which process comprises heating of said layer to effect removal of the solvent and conversion of the composition to the solid state.

15. A process for preparing a resistive element comprising a substrate having printed thereon a layer of the composition of claim 9 which process comprises heating of said. layer to effect removal of the solvent and. conversion of the composition to the solid state.

## Patentansprüche

1. Polymer-Dickfilmwiderstands-Zusammensetzung, umfassend:
(1) fein zerteilte leitfähige Metallteilchen mit einer spezifischen Oberfläche von 0,3 bis 3,0 m²/g,
(2) fein zerteiltes, aus Teilchen bestehendes Material, ausgewählt aus Kohlenstoff, Siliciumoxid, Aluminiumoxid und deren Mischungen, mit einer spezifischen Oberfläche von mehr als 100 m²/g,
(3) ein thermoplastisches Harz, gelöst in
(4) einem organischen Lösungsmittel,
wobei die Zusammensetzung innerhalb von 2,5 min im wesentlichen härtbar ist, indem sie auf eine Temperatur von 135 °C erwärmt wird, und wobei weiterhin das Volumenverhältnis zwischen dem aus Teilchen bestehenden Material und dem Harz wenigstens 3,5 und das Gewichtsverhältnis zwischen dem Lösungsmittel und dem Harz 3 bis 5 beträgt.

2. Zusammensetzung nach Anspruch 1, wobei das leitfähige Material aus der aus Silber, Gold, Kupfer und deren Mischungen bestehenden Gruppe ausgewählt ist.

3. Zusammensetzung nach Anspruch 1, wobei das leitfähige Metall eine spezifische Oberfläche von 0,7 bis 1,3 m²/g aufweist.

4. Zusammensetzung nach Anspruch 1, wobei das aus Teilchen bestehende Material eine spezifische Oberfläche von mehr als 200 m²/g aufweist.

5. Zusammensetzung nach Anspruch 1, wobei das thermoplastische Harz aus der aus Phenoxyharz, Epoxyharz, Vinylidenchlorid, Polyester, Polyurethan und deren Mischungen bestehenden Gruppe ausgewählt ist.

6. Zusammensetzung nach Anspruch 1, wobei das Lösungsmittel einen Flüchtigkeits-Parameter von mehr als 10 000 aufweist.

7. Zusammensetzung nach Anspruch 6, wobei das Lösungsmittel einen Flüchtigkeits-Parameter von 10 000 bis 50 000 aufweist.

8. Zusammensetzung nach Anspruch 1, das zur Herstellung des Widerstandselements eines Spannungsprüfers geeignet ist, umfassend:
(1) fein zerteilte Silberteilchen mit einer spezifischen Oberfläche von 0,3 bis 3,0 m²/g,
(2) fein zerteilte Kohlenstoffteilchen mit einer spezifischen Oberfläche von mehr als 100 m²/g,
(3) ein Phenoxyharz, gelöst in
(4) einem organischen Lösungsmittel mit einem Flüchtigkeitsparameter von 10 000 bis 50 000.

9. Polymer-Dickfilmwiderstands-Zusammensetzung, umfassend:
(1) fein zerteilte Kohlenstoffteilchen mit einer spezifischen Oberfläche von mehr als 100 m²/g,
(2) ein thermoplastisches Harz, gelöst in
(3) einem organischen Lösungsmittel,
wobei die Zusammensetzung innerhalb von 2,5 min im wesentlichen härtbar ist, indem sie auf eine Temperatur von 135 °C erwärmt wird, und wobei weiterhin das Volumenverhältnis zwischen dem Kohlenstoff und dem Harz wenigstens 3,5 und das Gewichtsverhältnis zwischen dem Lösungsmittel und dem Harz 3 bis 5 beträgt.

10. Zusammensetzung nach Anspruch 9, wobei die Kohlenstoffteilchen eine spezifische Oberfläche von mehr als 200 m²/g aufweisen.

11. Zusammensetzung nach Anspruch 10, wobei das thermoplastische Harz aus der aus Phenoxyharz, Epoxyharz, Vinylidenchlorid, Polyester, Polyurethan und deren Mischungen bestehenden Gruppe ausgewählt ist.

12. Zusammensetzung nach Anspruch 9, wobei das Lösungsmittel einen Flüchtigkeits-Parameter von mehr als 10 000 aufweist.

13. Zusammensetzung nach Anspruch 12, wobei das Lösungsmittel einen Flüchtigkeits-Parameter von 10 000 bis 50 000 aufweist.

14. Verfahren zur Herstellung eines Wiederstandselements, umfassend ein Substrat, auf dem eine Schicht der Zusammensetzung nach Anspruch 1 aufgedruckt ist, wobei das Verfahren das Erwärmen der Schicht umfaßt, wodurch das Entfernen des Lösungsmittels und die Umwandlung der Zusammensetzung in den Festzustand bewirkt wird.

15. Verfahren zur Herstellung eines Widerstandselements, umfassend ein Substrat, auf dem eine Schicht der Zusammensetzung nach Anspruch 9 aufgedruckt ist, wobei das Verfahren das Erwärmen der Schicht umfaßt, wodurch das Entfernen des Lösungsmittels und die Umwandlung der Zusammensetzung in den Festzustand bewirkt wird.

## Revendications

1. Composition pour résistance à couche épaisse, à base de polymère comprenant:
(1) des particules de métal conducteur finement divisées ayant une aire superficielle de 0,3 à 3,0 m²/g,
(2) un matériau particulaire finement divisé choisi parmi le carbone, la silice, l'alumine et leurs mélanges, ayant une aire superficielle supérieure à 100 m²/g,
(3) une résine thermoplastique, dissoute dans
(4) un solvant organique,
dans laquelle la composition étant pratiquement durcissable en une période de 2,5 minutes par chauffage à une température de 135°C, et, de plus, dans laquelle le rapport volumique matériau particulaire/résine est d'au moins 3,5, et le rapport pondéral solvant/résine est de 3 à 5.

2. Composition suivant la revendication 1, dans laquelle le métal conducteur est choisi dans le groupe consistant en argent, or, cuivre et leurs mélanges.

3. Composition suivant la revendication 1, dans laquelle le métal conducteur a une aire superficielle de 0,7 à 1,3 m²/g.

4. Composition suivant la revendication 1, dans laquelle le matériau particulaire a une aire superficielle supérieure à 200 m²/g.

5. Composition suivant la revendication 1, dans laquelle la résine thermoplastique est choisie dans le groupe consistant en résine phénoxy, résine époxy, résine de chlorure de vinylidène, polyester, polyuréthane et leurs mélanges.

6. Composition suivant la revendication 1, dans laquelle le solvant a un indice de volatilité supérieur à 10 000.

7. Composition suivant la revendication 6, dans laquelle le solvant a un indice de volatilité de 10 000 à 50 000.

8. Composition suivant la revendication 1, convenable pour la fabrication de l'élément résistif d'un indicateur de tension, comprenant :
(1) des particules d'argent finement divisées ayant une aire superficielle de 0,3 à 3,0 m²/g,
(2) des particules de carbone finement divisées ayant une aire superficielle supérieure à 100 m²/g,
(3) une résine phénoxy, dissoute dans
(4) un solvant organique ayant un indice de volatilité de 10 000 à 50 000.

9. Composition pour résistance à couche épaisse à base de polymère comprenant :
(1) des particules de carbone finement divisées ayant une aire superficielle supérieure à 100 m²/g,
(2) une résine thermoplastique, dissoute dans
(3) un solvant organique,
dans laquelle la composition étant pratiquement durcissable en une période de 2,5 minutes par chauffage à une température de 135°C et de plus, dans laquelle le rapport volumique carbone/résine est d'au moins 3,5, et le rapport pondéral solvant/résine est de 3 à 5.

10. Composition suivant la revendication 9, dans laquelle les particules de carbone ont une aire superficielle supérieure à 200 m²/g.

11. Composition suivant la revendication 10, dans laquelle la résine thermoplastique est choisie dans le groupe consistant en résine phénoxy, résine époxy, résine de chlorure de vinylidène, polyester, polyuréthane et leurs mélanges.

12. Composition suivant la revendication 9, dans laquelle le solvant a un indice de volatilité supérieur à 10 000.

13. Composition suivant la revendication 12, dans laquelle le solvant a un indice de volatilité de 10.000 à 50 000.

14. Procédé pour la préparation d'un élément résistif comprenant un substrat sur lequel est imprimée une couche de la composition suivant la revendication 1, lequel procédé comprenant le chauffage de cette couche pour effectuer l'élimination du solvant et la conversion de la composition à l'état solide.

15. Procédé pour la préparation d'un élément résistif comprenant un substrat sur lequel est imprimée une couche de la composition suivant la revendication 9, lequel procédé comprenant le chauffage de cette couche pour effectuer l'élimination du solvant et la conversion de la composition à l'état solide.
